# EUROPÄISCHE PATENTSCHRIFT

(11) **EP 0 585 797 B1**
(45) Veröffentlichungstag und Bekanntmachung des Hinweises auf die Patenterteilung: **27.03.1996**
(21) Anmeldenummer: 93113577.6
(22) Anmeldetag: 25.08.1993
(51) Int. Cl.: H01J 61/073, H01J 61/86, H01J 9/02

(54) **Hochdruckentladungslampe**
High-pressure discharge lamp
Lampe à décharge à haute pression

(30) Priorität: 02.09.1992 DE 4229317
(43) Veröffentlichungstag der Anmeldung: 09.03.1994
(73) Patentinhaber: Patent-Treuhand-Gesellschaft für elektrische Glühlampen mbH, D-81543 München (DE)
(72) Erfinder: Chodora, Josef, D-86845 Grossaitingen (DE)

(56) Entgegenhaltungen:
- WO-A-88/04396
- DE-A- 3 036 746
- FR-A- 2 271 663
- US-A- 4 859 239

## Beschreibung

Die Erfindung betrifft Hochdruckentladungslampen gemäß des Oberbegriffs des Patentanspruchs 1, wie sie vorzugsweise für Projektionszwecke z.B. für die Kinoprojektion oder für die Maskenprojektion bei der Belichtung von Halbleiterscheiben in der Mikrolithographie eingesetzt werden.

In der Kinoprojektion werden heute praktisch ausschließlich Xenonhochdrucklampen zwischen 0,5 bis 10 kW Leistungsaufnahme, in der Mikrolithographie vorzugsweise Quecksilberhochdrucklampen zwischen 0,2 bis 2 kW Leistungsaufnahme, verwendet.

In beiden Fällen handelt es sich um Lampen für Gleichstrombetrieb, d.h. , die Lichterzeugung erfolgt in einem Gleichstrombogen hoher Stabilität zwischen einer Kathode und einer Anode, wobei die Anoden jeweils thermisch extrem hoch belastet sind.

Grund hierfür ist die beim Eintritt der Elektronen aus der Entladung in die Stirnfläche der i.a. kugel- oder kegelstumpfförmigen Anodenvorderseite frei werdende Anodenverlustwärme, die sich aus den Anteilen für die Eintrittsarbeit (4,4 eV für Wolfram), den Anodenfall (ca. 1 eV) und die mittlere Plasmaelektronenenergie (ca. 1 eV) zusammensetzt und proportional mit dem Lampenstrom zunimmt.

Die Anoden bestehen daher aus hochschmelzendem Wolfram, dem Metall mit dem höchsten Schmelzpunkt (ca. 3680 K) und dem kleinsten Dampfdruck aller Metalle und sind möglichst groß, um über eine möglichst große wärmeabstrahlende Fläche eine Senkung der Anodenbetriebstemperaturen zu erreichen; der Anodengröße sind allerdings naturgemäß aus konstruktiven und Kostengründen relativ enge Grenzen gesetzt.

Für eine möglichst niedrige Anodenstirnflächentemperatur ist daneben auch eine wirksame Ableitung der Anodenverlustwärme von der Anodenstirnfläche wichtig. Hierfür ist ein hohes Wärmeleitvermögen des Wolframmaterials in diesem Bereich erforderlich.

Wegen der hohen Anodenstirnflächentemperaturen wird von dem verwendeten Wolframmaterial dort außerdem eine hohe Wärmekriechfestigkeit, d.h., eine hohe mechanische Festigkeit bei hoher Temperatur über eine möglichst lange Zeit erwartet, so daß es zu keiner die Lampenlebensdauer verkürzenden Verformung der dem Bogen zugewandten Anodenstirnfläche kommt.

Die an Anoden mit nicht ausreichender Wärmekriechfestigkeit auf der Stirnfläche durch Materialumlagerungen auftretenden Verformungen bestehen aus Kraterbildungen und -verursacht durch die beim Ein- und Ausschalten auftretenden Aufheiz- und Abkühlprozesse-Rißbildungen, an denen früher oder später lokal Temperaturen oberhalb der Schmelztemperatur des Wolframs auftreten. Dies führt zu starker Wolframverdampfung und damit zu starker, die Lampenlebensdauer einschränkender Kolbenschwärzung.

Das für die Herstellung der Anoden verwendete Wolframstabmaterial wird in einem pulvermetallurgischen Sinterverfahren hergestellt; nach dem Sintern der aus einem Wolframpulveransatz hergestellten Preßstäbe folgen mehrere Hämmerstufen, in denen das gesinterte Wolframstabmaterial umgeformt und verdichtet wird.

Beide für die Anodenstandzeit so wichtige Parameter -Wärmeleitvermögen und Wärmekriechfestigkeit- nehmen mit der Verdichtung des Wolframmaterials zu; zum einen wegen der höheren Dichte, die Wärmekriechfestigkeit zusätzlich wegen der durch die Verdichtung erzielten höheren Feinkörnigkeit des Gefüges, das dann aufgrund der größeren Zahl von Korngrenzen in der Volumeneinheit thermisch bedingten Materialumlagerungen einen größeren Widerstand entgegensetzt.

Bei diesen Umform- und Verdichtungsprozessen wirken die angreifenden Hämmerkräfte jedoch im wesentlichen radial, d.h., Umformung und Verdichtung erfolgen von der Mantelfläche her, die Verdichtung -und damit auch Wärmekriechfestigkeit und Wärmeleitfähigkeitnehmen daher vom Stabmantel zur Stabmitte hin ab.

D.h., gerade im Mittenbereich der Anodenstirnfläche, dort, wo der Bogenkern ansetzt und die höchste Temperatur herrscht, hat das Wolframstabmaterial die geringste Verdichtung erfahren, dort besitzt es die kleinste Dichte, die kleinste Wärmeleitfähigkeit und die kleinste Wärmekriechfestigkeit!

Eine Xenonhochdrucklampe ist aus DE-A-3 036 746 bekannt. Deren Anode wird aus einem aus Wolfram und Silizium-, Aluminium- oder Kaliumzusätzen gebildeten Gemisch durch Sintern, Schmieden und Spanabhebender Bearbeitung mit nachfolgender Wärmebehandlung hergestellt.

Der vorliegenden Erfindung liegt die Aufgabe zugrunde eine Erhöhung der Wolframmaterialverdichtung und damit eine Erhöhung von Wärmeleitfähigkeit und Wärmekriechfestigkeit des Wolframmaterials im Mittenbereich der Anodenstirnfläche zu erreichen, um so eine Verformung der Anodenstirnfläche und die daraus folgenden lokalen Temperaturerhöhungen und damit jede stärkere Wolframverdampfung und die daraus resultierende, die Lampenlebensdauer begrenzende Kolbenschwärzung zeitlich hinauszuschieben oder ganz auszuschließen.

Diese Aufgabe wird erfindungsgemäß durch die kennzeichnenden Merkmale des Anspruchs 1 gelöst.

Anspruch 7 gibt eine spezielle Elektrodenausführung an, Anspruch 8 ein entsprechendes Herstellungsverfahren.

Besonders vorteilhafte Ausgestaltungen finden sich in den Unteransprüchen.

Eine erfindungsgemäße Elektrode ist die Anode einer gleichstrombetriebenen Xenon- oder Quecksilberhochdrucklampe, deren der Entladung zugewandte Stirnfläche durch axiales Schmieden verdichtet ist.

Dazu werden die Anodenrohlinge in einem elektrisch beheizten Muffelofen auf etwa 1400°C erhitzt und anschließend einzeln mit einer Zange aus dem Ofen in ein Gesenk gestellt und mit einem pneumatischen Schmiedehammer von ca. 400 kg Gewicht mit ca. 10 - 15 Schlägen in wenigen Sekunden auf Gesenkhöhe geschmiedet.

Dabei erfolgt eine axiale Stauchung des kegelstumpfförmigen Vorderteils des Anodenrohlings um einige mm; damit verbunden ist eine deutliche Verdichtung des Wolframmaterials in diesem Bereich sowie eine Gefügeänderung in Richtung eines feinkörnigeren Gefüges.

Die Erfindung wird nachfolgend anhand mehrerer Figuren verdeutlich. Es zeigen:
- Figur 1: eine Xenonhochdrucklampe von 2500 W Nennleistung in Seitenansicht
- Figur 2: in Draufsicht die Anode aus einer Xenonhochdrucklampe von 2500 W Nennleistung mit nicht axial geschmiedeter Stirnfläche nach 1200 Brennstunden
- Figur 3: in Draufsicht die Anode aus einer Xenonhochdrucklampe von 2500 W Nennleistung mit axial geschmiedeter Stirnfläche nach 1200 Brennstunden
- Figur 4: das Schliffbild eines Anodenrohlings vor dem axialen Schmieden
- Figur 5: das Schliffbild einer Anode mit durch axiales Schmieden verdichteter Stirnfläche
- Figur 6: die Lage der Meßpunkte auf dem Anodenschliff (schematisch), an denen die Härte bestimmt wurde
- Figur 7: Härtemeßwerte im vorderen, verdichteten und im hinteren, praktisch unverdichteten Anodenbereich.

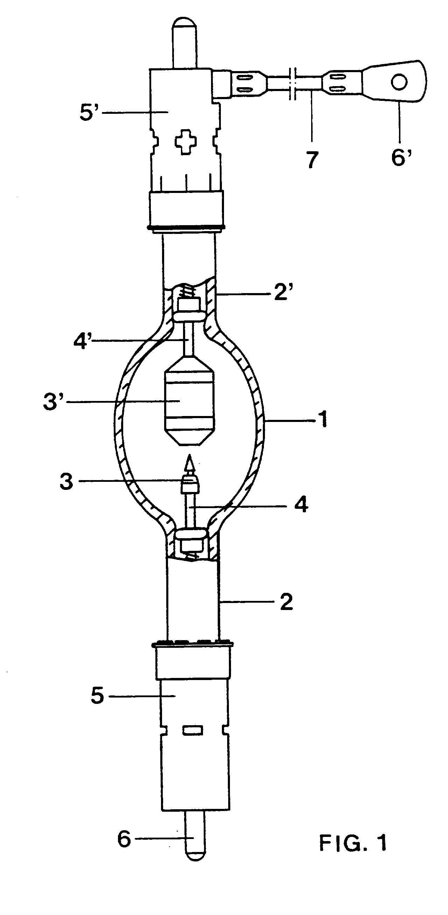

Bei der in Figur 1 in Seitenansicht dargestellten Xenonkurzbogenhochdrucklampe für Gleichstrombetrieb von 2500 W Nennleistung stehen sich im mit Xenon von ca. 10 bar Druck gefüllten Kolben 1 aus Quarzglas mit zwei Kolbenhälsen 2, 2' -ebenfalls aus Quarzglas-zwei Elektroden, die Kathode 3 und die Anode 3' diametral in einem Abstand von wenigen mm gegenüber. Die thermisch hoch belastete, vergleichsweise große Anode ist auf ihrer der Entladung zugewandten Vorderseite zur Erzielung einer möglichst hohen Bogenstabilität kegelstumpfartig geformt. Die Elektroden 3, 3' sind auf stabförmigen Stromzuführungen aus Wolfram an den Elektrodenstäben 4, 4' montiert. Die Elektrodenstäbe 4, 4' sind an den kolbenfernen Enden der Kolbenhälse 2, 2' gasdicht eingeschmolzen, nach außen geführt und über Litzen elektrisch leitend mit auf den Kolbenhälsen 2, 2' aufgekitteten Lampensockeln 5, 5' verbunden. Der elektrische Anschluß an die Versorgungsspannung erfolgt kathodenseitig (unten) durch Klemmung über den Sockelstift 6, anodenseitig (oben) über Sockelkabel 7 und durch Klemmung über den Kabelschuh 6' . Die Lampenspannung beträgt nur ca. 28 V, der Lampenstrom ca. 90 A, die Anodenstirnflächentemperatur ca. 2500 K.

Solche Lampen werden wegen ihrer tageslichtähnlichen Strahlung und sehr hohen Leuchtdichte vorzugsweise in der Kinoprojektion eingesetzt; ihre durch Kolbenschwärzung begrenzte Lebensdauer liegt zwischen 1200 - 1500 Brennstunden; wegen der teuren Vormaterialien -Wolfram, Quarzglas, Xenon u.a.- und des relativ hohen Anteils von Handarbeit bei ihrer Herstellung sind diese Lampen vergleichsweise teuer und ein vorzeitiger Lampenausfall aus Kosten- und Wettbewerbsgründen äußerst unerwünscht.

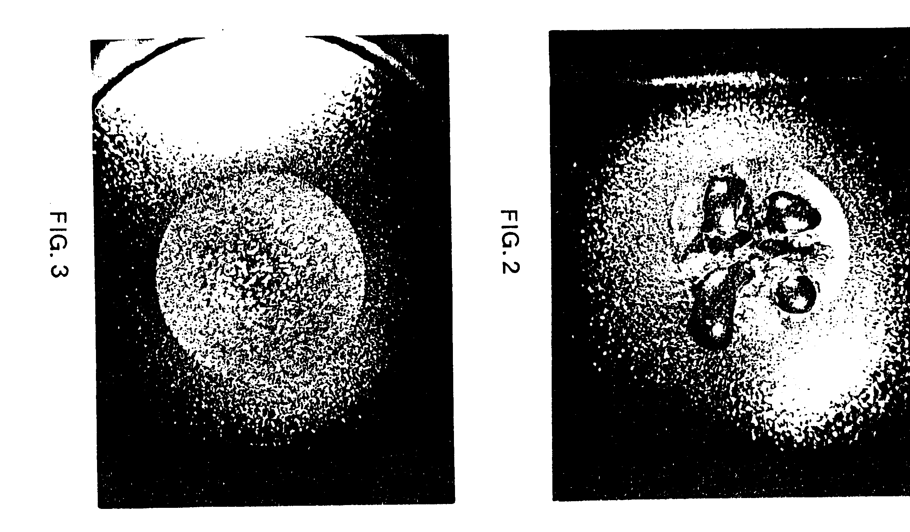

Figur 2 zeigt in Draufsicht eine Anode mit einer nicht zusätzlich durch Schmieden verdichteten Anodenstirnfläche aus einer Xenonhochdrucklampe von 2500 W Nennleistung nach 1200 Brennstunden. Die Stirnfläche ist stark verformt und zeigt Schmelzperlen, d.h., daß lokal die Schmelztemperatur von Wolfram -3680 K-überschritten worden ist, was dann zu starker Wolframabdampfung und damit entsprechend starker, die Lampenlebensdauer begrenzender Kolbenschwärzung führt.

Figur 3 zeigt ebenfalls in Draufsicht eine Anode aus einer Xenonhochdrucklampe von 2500 W Nennleistung nach 1200 Brennstunden, deren Stirnfläche zusätzlich durch Schmieden verdichtet worden war.
Die Stirnfläche dieser Anode zeigt praktisch keine Verformungen, damit fehlen lokale Temperaturerhöhungen und somit auch jede stärkere Kolbenschwärzung. Eine Lampe mit solcher Anode wird die angegebene Lebensdauer von 1200 - 1500 Brennstunden mit Sicherheit erreichen und überschreiten.

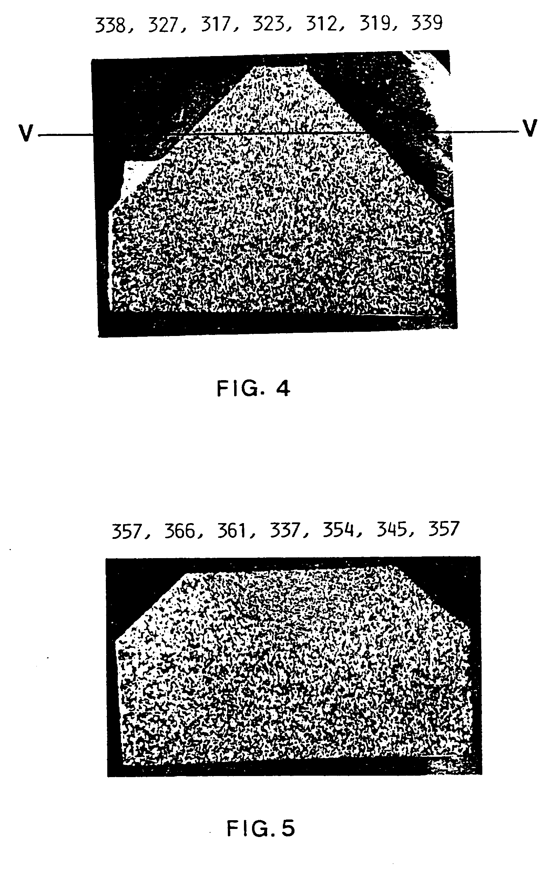

Figur 4 zeigt im Schliffbild das kegelstumpfförmige Vorderteil eines Anodenrohlings vor dem axialen Schmieden.

Der Kegelstumpf besitzt eine Höhe von ca. 8 mm, die Stirnfläche hat einen Durchmesser von nur ca. 3 mm. Der Anodenrohling zeigt überall praktisch das gleiche Gefüge.

Die eingetragenen Zahlen bedeuten die in Höhe der eingezeichneten Linie V-V, die die spätere Lage der Anodenstirnfläche angibt, quer über den Schliff etwa äquidistant gemessene Vickershärte HV5 (kg/mm); bei gleichem Gefüge ist die Härte ein Maß für die Dichte des Wolframmaterials und damit für seine Wärmeleitfähigkeit und Wärmekriechfestigkeit. Die Werte zeigen auf der Achse ein Minimum und steigen zum Mantel hin an.

Figur 5 zeigt das Schliffbild des Vorderteils einer fertig geschmiedeten und danach durch überdrehen der Oberfläche überarbeiteten Anode.

Die Kegelstumpfhöhe beträgt nach axialer Stauchung um ca. 2,5 mm und Überdrehen nur noch ca. 4 mm, der Durchmesser der Stirnfläche ca. 12 mm; das Gefüge ist in einem halbkugeligen Bereich bis zu einer Tiefe von einigen mm erkennbar feinkörniger geworden.

Die überschriebenen Zahlen geben wieder die Vickershärte HV5 (kg/mm) an, etwa äquidistant quer über dem Schliff dicht unter der Anodenstirnfläche gemessen. Die Werte liegen deutlich über den an dem Anodenrohling vor dem Schmieden gemessenen Wert, das beim Anodenrohling auf der Achse gemessene, ausgeprägte Minimum der Härte fehlt.

Die in den Figuren 4 und 5 angegebenen Meßwerte sind Einzelmeßwerte, die naturgemäß infolge von Meßunsicherheiten und Schwankungen im Schmiedeprozeß eine gewisse Streuung zeigen.

So liegt der am ungeschmiedeten Rohling auf der Achse gemessene Härtewert mit 323 über den benachbarten Werten (317, 312), unter Berücksichtigung der Meß- und Verfahrensunsicherheiten ist jedoch zu erkennen, daß die Härte (und bei homogenem Gefüge damit die Dichte) vom Mantel zur Achse hin deutlich abnimmt.

Der bei der geschmiedeten Anode nahe der Vorderfläche auf der Achse gemessene Härtewert von 337 ist offensichtlich ein Ausreißer nach unten, alle anderen Werte liegen mit einer akzeptablen Streuung um den Mittelwert von rund 354.

Um sowohl die Meßunsicherheiten als auch Schwankungen im Schmiedeverfahren selbst zu erfassen, wurden daher in Fertigungsentnahmeprüfungen Härtemessungen an insgesamt sieben Anodenschliffen vorgenommen und jeweils die Mittelwerte und Standardabweichungen bestimmt.

Alle Schliffe wurden nach dem erfindungsgemäßen axialen Schmieden der Anodenrohlinge und anschließendem Überdrehen der Vorderfläche durch das übliche Zertrennen des interessierenden vorderen Anodenteils in einer Ebene durch die Anodenlängsachse hergestellt.

Beim spanabhebenden Überdrehen wird jeweils eine ca. 1,5 mm starke Schicht verformten Materials von der Anodenstirnfläche und der konischen Mantelfläche abgetragen. Dadurch wird zum einen die Anodengeometrie und zum anderen ein etwa homogenes Gefüge an der Anodenstirnfläche erreicht.

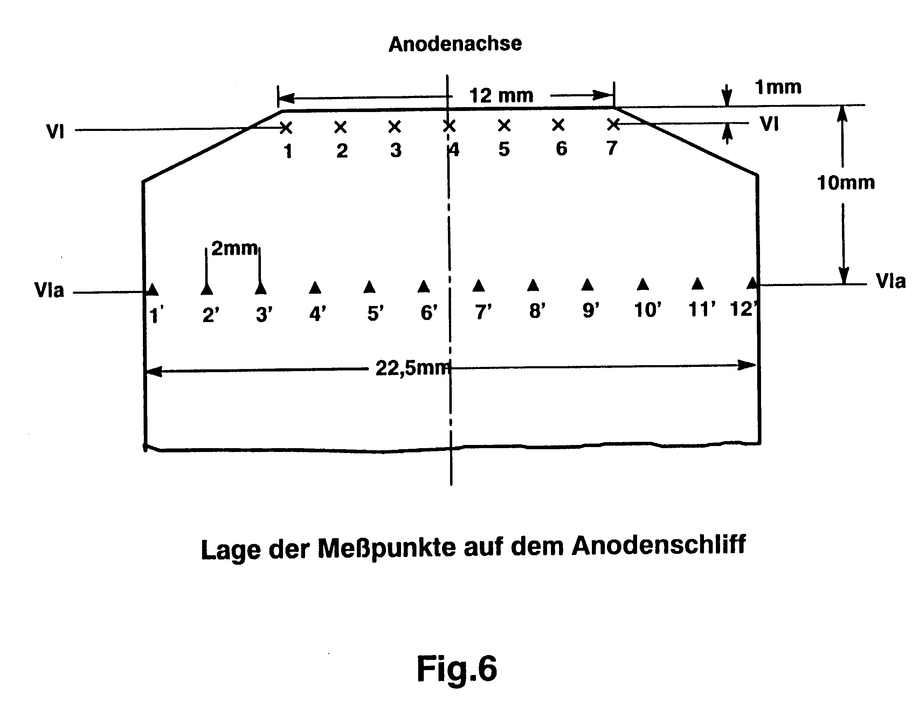

Auf der geschliffenen, polierten und geätzten Trennfläche der Anodenschliffe wurde dann die Vickershärte HV5 (kg/mm) jeweils im Abstand von 2 mm auf einer Linie VI-VI (ca. 12 mm lang) dicht (ca. 1 mm) unter der überdrehten Anodenvorderfläche im vorderen Verdichtungsbereich (7 Werte) und zum Vergleich auf einer zweiten Linie VIa-VIa über den Durchmesser (22,5 mm) ca. 10 mm unter der Anodenvorderfläche in einem hinteren, praktisch unverdichteten Bereich (12 Werte) gemessen (siehe Figur 6).

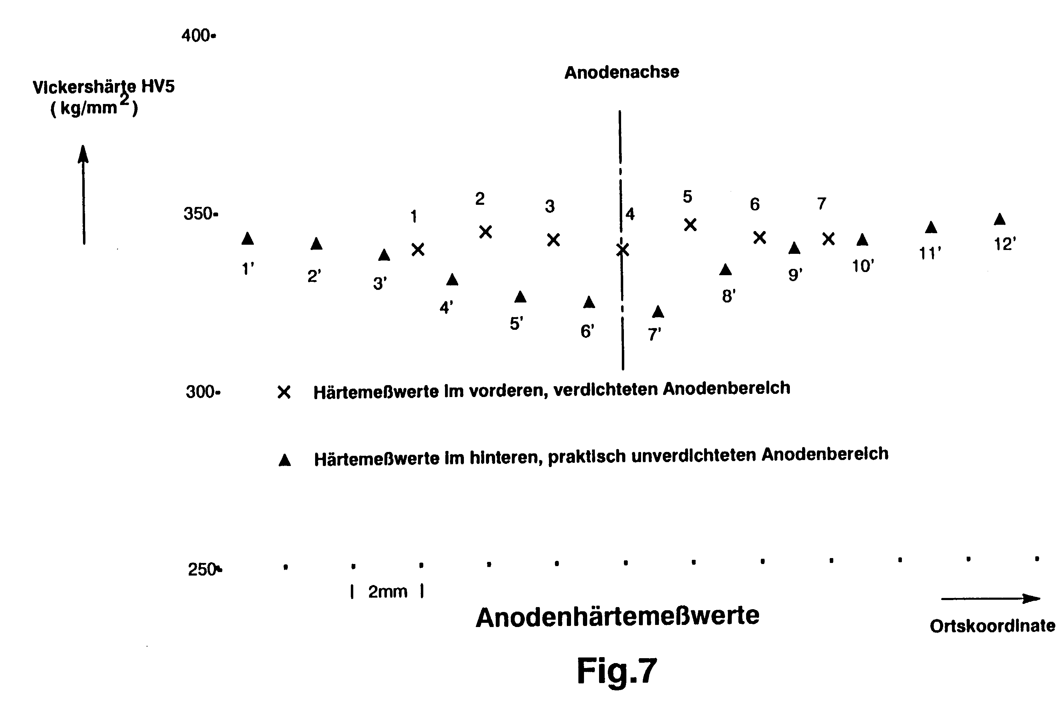

Die erhaltenen Meßwerte sowie die daraus berechneten Mittelwerte und die dazugehörigen Standardabweichungen sind in den beiliegenden Tabellen 1 und 2 zusammengestellt und in Figur 7 graphisch dargestellt.

Man erkennt, daß die Härte im axial verdichteten Bereich nahe der Anodenvorderfläche zwischen Rand und Achse tatsächlich praktisch konstant ist, während im hinteren, praktisch axial nicht verdichteten Bereich die Härte im Achsenbereich signifikant -um mehr als 15 kg/mm- niedriger ist als am Rand.

Beides -Verdichtung und die beobachtete Gefügeänderung- haben Anteil an der auf der Anodenstirnfläche gemessenen Erhöhung der Härte als auch an der für die Erhöhung der Anodenlebensdauer verantwortlichen Vergrößerung von Wärmeleitfähigkeit und Wärmekriechfestigkeit in diesem Bereich.

**Tabelle1**

| **Härtemessungen im vorderen, verdichteten Anodenbereich (Vickershärte HV5 in kg/qmm)** | | | | | | | |
|---|---|---|---|---|---|---|---|
| Anode Nr. | Punkt 1 | Punkt2 | Punkt 3 | Punkt 4 | Punkt 5 | Punkt 6 | Punkt 7 |
| 1 | 357 | 366 | 361 | 337 | 354 | 345 | 357 |
| 2 | 332 | 332 | 341 | 341 | 341 | 329 | 336 |
| 3 | 336 | 349 | 345 | 345 | 349 | 347 | 332 |
| 4 | 336 | 341 | 345 | 341 | 341 | 345 | 341 |
| 5 | 342 | 352 | 351 | 348 | 354 | 342 | 342 |
| 6 | 332 | 329 | 321 | 329 | 336 | 341 | 341 |
| 7 | 343 | 341 | 329 | 332 | 345 | 345 | 341 |
| **Mittelwert** | **339,7** | **344,3** | **341,9** | **339,0** | **345,7** | **342,0** | **341,4** |
| **Standardabweichung** | **±8,8** | **±12,7** | **±13,4** | **±6,8** | **±6,9** | **±6,1** | **±7,8** |

**Tabelle2**

| **Härtemessungen im hinteren, praktisch unverdichteten Anodenbereich (Vickershärte HV5 in kg/qmm)** | | | | | | | | | | | | |
|---|---|---|---|---|---|---|---|---|---|---|---|---|
| Anode Nr. | Punkt 1 | Punkt 2 | Punkt 3 | Punkt 4 | Punkt 5 | Punkt 6 | Punkt 7 | Punkt 8 | Punkt 9 | Punkt 10 | Punkt 11 | Punkt 12 |
| 1 | 348 | 345 | 336 | 334 | 334 | 327 | 321 | 325 | 331 | 335 | 335 | 341 |
| 2 | 341 | 341 | 338 | 329 | 310 | 329 | 317 | 325 | 332 | 329 | 345 | 347 |
| 3 | 336 | 336 | 336 | 329 | 323 | 321 | 323 | 345 | 345 | 336 | 343 | 336 |
| 4 | 341 | 345 | 345 | 336 | 329 | 329 | 323 | 349 | 345 | 345 | 349 | 345 |
| 5 | 341 | 341 | 332 | 321 | 332 | 321 | 321 | 329 | 343 | 349 | 345 | 349 |
| 6 | 347 | 341 | 345 | 336 | 321 | 317 | 323 | 323 | 341 | 349 | 349 | 345 |
| 7 | 349 | 343 | 336 | 332 | 332 | 325 | 321 | 336 | 336 | 345 | 345 | 362 |
| **Mittelwert** | **343,3** | **341,7** | **338,3** | **331,0** | **325,9** | **324,1** | **321,3** | **333,1** | **339,0** | **341,1** | **344,4** | **346,4** |
| **Standardabweichung** | **±4,8** | **±3,1** | **±4,9** | **±5,3** | **±8,5** | **±4,6** | **±2,1** | **±10,4** | **±6,0** | **±7,8** | **±4,7** | **±8,1** |

## Patentansprüche

1. Hochdruckentladungslampe mit einem abgedichteten, lichtdurchlässigen Kolben (1), in dem sich zwei Elektroden (3, 3') aus hochschmelzendem Material diametral einander gegenüberstehen, die über gasdicht in den Kolben (1) eingeschmolzene Stromdurchführungen (4, 4') elektrisch leitend mit den Lampensockeln (5, 5') verbunden sind, dadurch gekennzeichnet, daß das Elektrodenmaterial an der dem Entladungsraum zugewandten Stirnfläche bei mindestens einer der Elektroden im ganzen Stirnflächenbereich oder einem Teil davon mechanisch durch Schmieden verdichtet ist.

2. Hochdruckentladungslampe nach Anspruch 1, dadurch gekennzeichnet, daß die mechanische Verdichtung des Elektrodenmaterials im Stirnflächenbereich durch axiales Schmieden erreicht ist.

3. Hochdruckentladungslampe nach Anspruch 1, dadurch gekennzeichnet, daß die geschmiedete Elektrode im gesamten verdichteten Stirnflächenbereich praktisch die gleiche Härte aufweist.

4. Hochdruckentladungslampe nach Anspruch 1, dadurch gekennzeichnet, daß die geschmiedete Elektrode im gesamten verdichteten Stirnflächenbereich praktisch das gleiche Gefüge aufweist .

5. Hochdruckentladungslampe nach Anspruch 1, dadurch gekennzeichnet, daß die geschmiedete Elektrode im verdichteten Stirnflächenbereich eine kleinere mittlere Korngröße aufweist als im hinteren, unverdichteten Elektrodenbereich.

6. Hochdruckentladungslampe nach Anspruch 1, dadurch gekennzeichnet, daß die geschmiedete Elektrode aus Wolfram ist.

7. Elektrode für eine Hochdruckentladungslampe aus hochschmelzendem Material, dadurch gekennzeichnet, daß das Elektrodenmaterial im dem Entladungraum zugewandten Stirnflächenbereich durch axiales Schmieden mechanisch verdichtet ist.

8. Verfahren zur Herstellung einer Elektrode nach Anspruch 7, dadurch gekennzeichnet, daß vor dem spanabhebenden Formen der Elektrodengeometrie der zylinderförmige Elektrodenrohling eine Materialverdichtung durch axiales Schmieden an mindestens einer Stirnfläche erfährt.

9. Verfahren zur Herstellung einer Elektrode nach Anspruch 7, dadurch gekennzeichnet, daß die Schmiedetemperatur t = 1400 ± 200°C beträgt.

## Claims

1. High-pressure discharge lamp having a sealed, light-transparent bulb (1) in which two electrodes (3, 3') of refractory material are situated diametrically opposite one another, which electrodes are connected in an electrically conducting manner to the lamp caps (5, 5') via current leadthroughs (4, 4') fuse-sealed in a gastight manner into the bulb (1), characterized in that, in the case of at least one of the electrodes, the electrode material is mechanically compacted by forging at the end face adjacent to the discharge space in the entire end-face region or a part thereof.

2. High-pressure discharge lamp according to Claim 1, characterized in that the mechanical compaction of the electrode material in the end-face region is achieved by axial forging.

3. High-pressure discharge lamp according to Claim 1, characterized in that the forged electrode virtually has the same hardness in the entire compacted end-face region.

4. High-pressure discharge lamp according to Claim 1, characterized in that the forged electrode virtually has the same microstructure in the entire compacted end-face region.

5. High-pressure discharge lamp according to Claim 1, characterized in that the forged electrode has, in the compacted end-face region, a smaller mean grain size than in the rear, uncompacted electrode region.

6. High-pressure discharge lamp according to Claim 1, characterized in that the forged electrode is of tungsten.

7. Electrode for a high-pressure discharge lamp of refractory material, characterized in that the electrode material is mechanically compacted in the end-face region adjacent to the discharge space by axial forging.

8. Method of producing an electrode according to Claim 7, characterized in that, prior to the shaping of the electrode geometry by metal cutting, the cylindrical electrode blank undergoes a material compaction by axial forging at at least one end face.

9. Method of producing an electrode according to Claim 7, characterized in that the forging temperature is t = 1400 ± 200°C.

## Revendications

1. Lampe à décharge haute pression, comportant une ampoule transparente (1) fermée de façon étanche, dans laquelle sont disposées dans des positions diamétralement opposées deux électrodes (3,3') en un matériau à haut point de fusion, qui sont reliées d'une manière électriquement conductrice aux embases de la lampe (5,5'), par l'intermédiaire de traversées de courant (4,4') scellées par fusion d'une manière étanche au gaz dans l'ampoule (1), caractérisée par le fait que le matériau des électrodes est densifié mécaniquement par forgeage sur la totalité ou une partie de la surface frontale, tournée vers l'espace de décharge, pour au moins l'une des électrodes.

2. Lampe à décharge haute pression suivant la revendication 1, caractérisée par le fait que la densification mécanique du matériau des électrodes dans la zone de la surface frontale est obtenue par forgeage axial.

3. Lampe à décharge haute pression suivant la revendication 1, caractérisée par le fait que l'électrode forgée possède pratiquement la même dureté dans toute la zone densifiée de la surface frontale.

4. Lampe à décharge haute pression suivant la revendication 1, caractérisée par le fait que l'électrode forgée possède pratiquement la même structure, dans toute la zone densifiée de la surface frontale.

5. Lampe à décharge haute pression suivant la revendication 1, caractérisée par le fait que l'électrode forgée possède, dans la zone densifiée de la surface frontale, une granulométrie moyenne plus petite que dans la partie arrière non densifiée des électrodes.

6. Lampe à décharge haute pression suivant la revendication 1, caractérisée par le fait que l'électrode forgée est en tungstène.

7. Electrode pour une lampe à décharge haute pression en un matériau à haut point de fusion, caractérisée en ce que le matériau de l'électrode est densifié mécaniquement par forgeage axial dans la partie de la surface frontale, tournée vers l'espace de décharge.

8. Procédé pour fabriquer une électrode suivant la revendication 7, caractérisé par le fait qu'avant d'obtenir, par enlèvement de copeaux, la géométrie de l'électrode, on soumet l'ébauche de forme cylindrique de l'électrode à une densification par forgeage axial dans la zone d'au moins une surface frontale.

9. Procédé pour fabriquer une électrode suivant la revendication 7, caractérisé par le fait que la température de forgeage est t = 1400 ± 200°C.
